(19) Europäisches Patentamt
European Patent Office
Office européen des brevets

(11) **EP 2 249 457 A1**

(12) **EUROPEAN PATENT APPLICATION**

(43) Date of publication:
**10.11.2010 Bulletin 2010/45**

(51) Int Cl.:
***H02J 7/35*** *(2006.01)*     ***H01L 31/02*** *(2006.01)*

(21) Application number: **09159824.3**

(22) Date of filing: **08.05.2009**

(84) Designated Contracting States:
**AT BE BG CH CY CZ DE DK EE ES FI FR GB GR HR HU IE IS IT LI LT LU LV MC MK MT NL NO PL PT RO SE SI SK TR**

(71) Applicant: **NXP B.V.**
**5656 AG Eindhoven (NL)**

(72) Inventors:
• **Bergveld, Hendrik Johannes**
  **5656 AE Eindhoven (NL)**

• **Schoofs, Franciscus A.C.M.**
  **5656 AE  Eindhoven (NL)**
• **Hoogzaad, Gian**
  **5656 AE  Eindhoven (NL)**

(74) Representative: **Schouten, Marcus Maria et al**
**NXP B.V.**
**IP & L Department**
**High Tech Campus 32**
**5656 AE Eindhoven (NL)**

(54)    **PV solar cell**

(57)    The present invention relates to the field of increasing the power efficiency of photovoltaic systems with solar cell(s) (801) or modules by compensating for output-power loss caused by insolation difference and mismatch.

In practical cases, differences will exist between output powers of the solar cells in various modules, e.g. due to (part of) the modules being temporarily shaded, pollution on one or more solar cells, or even spread in solar-cell behaviour that may become worse during aging. Due to the current-source-type behaviour of solar cells and their series connection these differences will lead to a relatively large drop in output power coming from the PV system. This invention addresses this problem by adding DC/DC converters (803) on a single or multiple solar-cell level that add or subtract difference currents thereby increasing the output power of the complete PV system. As a distinguishing feature compared to state-of-the-art, the series and parallel connections of the solar modules in the PV system arc left in tact.

**Fig. 8**

## Description

FIELD OF THE INVENTION

The present invention relates to increasing power efficiency of photovoltaic systems with solar cell (s) or modules by compensating for output-power loss caused by insolation difference and mismatch, to systems comprising said solar cells and to a method of operating said solar cells.

BACKGROUND OF THE INVENTION

Photovoltaic (PV) systems are increasingly used to generate electrical energy from solar energy falling on solar modules. Typically, each solar module is formed by placing a large amount of solar cells in series. A PV system is then formed by placing a number of solar modules in series in a string and sometimes by placing multiple strings of in-series-connected solar modules in parallel, depending on the desired output voltage and power range of the PV system. In practical cases, differences will exist between output powers of individual solar cells in the various modules, e.g. due to (part of) the modules being temporarily shaded, pollution on one or more solar cells, or even spread in solar-cell behavior that may become worse during aging. Due to the current-source-type behavior of solar cells and their series connection these differences will lead to a relatively large drop in output power coming from a PV system.

A solar cell converts incoming solar energy into electrical energy. On today's market, two distinct types of cells can be distinguished. First of all, several types of single-junction and multiple-junction crystalline-silicon-based solar cells exist. Secondly, various types of thin-film solar cells are being introduced. The single-junction mono or multi-crystalline silicon-based solar cells dominate today's market (>80% market share) and have a power conversion efficiency of up to roughly 20%, with a theoretical maximum of 27%. Multi-junction cells, based e.g. on III-V semiconductors and multiple stacked PN junctions tuned at different wavelengths of light achieve efficiencies of 40% and higher, but these currently only exist in laboratories and still have to find their way to mass production at an acceptable cost level. Various thin-film technologies together take up to 20% of today's market. Examples of thin-film technologies are CdTe (Cadmium Telluride) and CIGS (Copper Indium Gallium Selenium). Efficiencies are generally below 10%, but costs are significantly lower than for crystalline-silicon-based cells. Thin-film technologies are expected to take an increasing market share at the cost of crystalline cells in the future, but both are expected to co-exist in future markets.

Fig. 1 shows an (a) Equivalent circuit model of a typical solar cell, and (b) an I-V characteristic of solar cell for two light conditions.

Fig. 2 shows an (a) I-V and (b) a P-V characteristic of a typical solar module with 36 solar cells in series as a function of incoming light [mW/cm$^2$] and temperature [°C].

In order to form a PV system, several modules are usually placed in series in a string and several strings are placed in parallel. This is referred to as an array. How the modules are arranged in the array strongly depends on the application. Basically, four groups of applications can be distinguished:

1. Stand-alone systems

In a stand-alone PV system there is no connection to a mains grid. Such a system is mainly applied in road signage or in places where there is no infrastructure, such as remote locations or in developing countries. Power ranges are typically from 100 W-1 kW. In most cases, a single module will fulfill a desired function, where e.g. a lead-acid battery is charged during the day and either DC loads are connected at night or an inverter is used to boost e.g. a 12 V DC up to e.g., 110 Vrms AC to accommodate AC loads up to a few 100 W.

2. Residential systems

In residential applications solar modules are placed in an appropriate series-parallel fashion to achieve a desired voltage level at an input of the DC/AC inverter that connects a PV system to a grid. Practical inverters have a certain DC input voltage range within which Maximum Power Point Tracking (MPPT) can be performed for all modules simultaneously. A voltage range of the PV system under all practical conditions (anticipated light and temperature variations) should be chosen such that it always falls within a required input range of an inverter. This determines the amount of modules placed in series. Depending on a required output power, several strings of modules can be placed in parallel. Practical powers for residential systems range from 1-10 kW. Energy obtained from a residential system is used in the house on which roof it is placed. Optionally, excess power can be delivered back to a mains grid. In the latter case, a two-way electricity meter is needed to calculate the net cost of electricity.

3. Commercial systems

Commercial PV systems are scaled-up versions of residential systems, e.g. placed on roofs of large buildings and exploited commercially. The owner of the building usually signs a contract with a utility company about an amount of electrical energy to be delivered over an agreed time span. Similar remarks with regards to series and parallel connections of modules can be made as for residential systems. Practical power ranges are from 10 kW to 1 MW.

4. Solar plants

Solar plants are typically operated by utility companies to generate electrical energy for large numbers of houses. Solar plants are placed in large fields and deserts and occupy large areas. (Partial) shading is much less likely to appear now and also pollution will occur less or during a shorter time span than for residential and commercial applications, since operators will clean modules when applicable. This is a fundamental difference with residential and commercial systems, where maintenance is less likely to occur. Powers are in the order of at least 1 MW or larger. Again, similar remarks hold for the number of panels placed in series/parallel. In any case, large amounts of strings are placed in parallel, since a practical input range of a central inverter is still 100s of V, implying e.g. 20 modules of 30 V each in series with e.g. 4 kW per string.

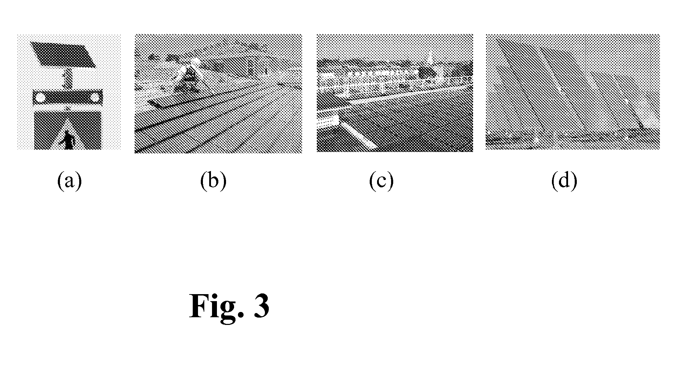

As illustration, Fig. 3 shows a picture of each of the four PV system types described above.

A typical module used in residential applications contains 60 cells in series. At 1000 W/m$^2$ and with an MPP current of roughly 7.5 A (which is 7% lower than an insolation current $I_{ins}$ of 8 A) and an MPP voltage of 0.5 V per cell, the output power is 60*7.5 A*0.5 V=225 W when operated at MPP. With a typical surface area per solar cell of 15 cm*15 cm, this module is roughly 1.5 m$^2$ in size, which is e.g. still practical for installers. As an example, a 5 kW residential PV system would then contain roughly 22 modules, occupying a surface area of roughly 33 m$^2$.

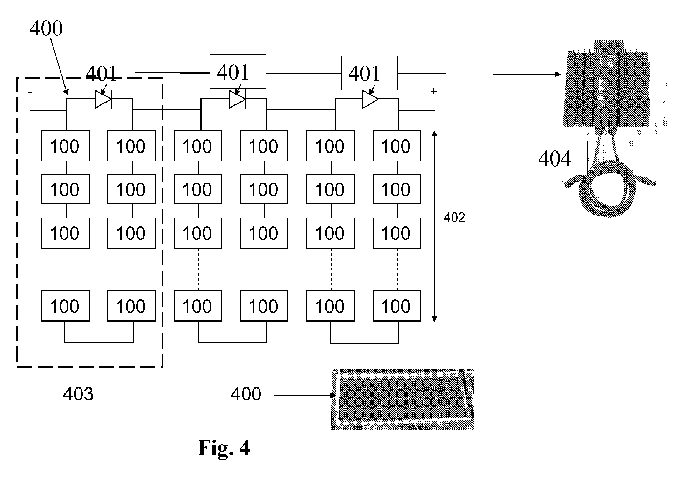

Due the current-source-type behavior of solar cells as described above and the fact that the value of the solar current per cell depends on the amount of incoming light, not all current sources connected in series inside a module may have the same value. In order to prevent that a current of a weakest cell determines the output current of the whole module, bypass diodes are typically used inside the module. Practically, these bypass diodes are placed across each group of 18-24 solar cells. An example is shown in Fig. 4 for a solar module (400) consisting of 54-72 cells (100) in series, typically in a meander-type fashion with a width of 9-12 cells (402) and one bypass diode (401) per 18-24 cells. The number of cells is typically coupled to the breakdown voltage of the solar cells used. A segment (403) comprising one series of solar cells and a bypass diode (401) is indicated as well. The 3 diodes in figure 4 are typically placed in a junction box (404) with a heat sink that is placed on the backside of each module.

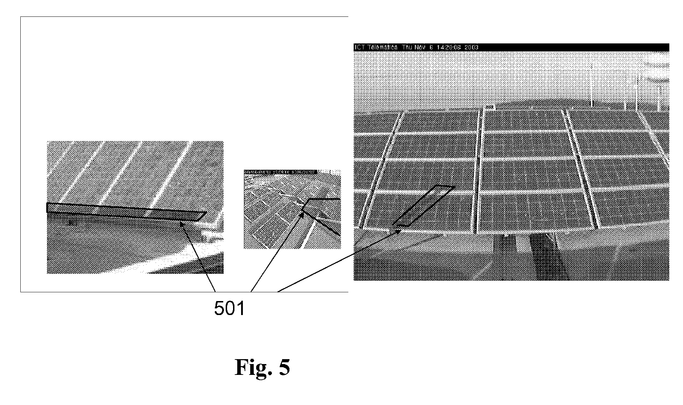

In practice, many reasons exist why an output current of one cell will not be equal to that of another. Examples are shading, local contaminations on a module (e.g. bird droppings, leafs, etc), and spread between cells (aggravated by aging). The most prominent is that of (partial) shading, where one or more cells in one or several modules receive less incoming light than others, leading to lower $I_{ins}$ values than that of other cells. In practice, shading of a cell may lead to 40-50% less incoming light than cells that have no shadow across them. In practical systems, partial shading will only occur during a certain part of the day and most of the day all cells will be in bright sunlight. Some examples of partially shaded modules (501) in practical PV systems are shown in Figure 5. As can be seen, only small portions of the modules therein are in the shade. As will be explained below, this will lead to a relatively large decrease in output power of the PV system in question.

Addition of DC/DC or DC/AC converters (micro inverters) on module level will help to reduce a decrease in output level DC/DC converters could for instance relate to addition of powers, and will further be referred to as "sigma converter". An example thereof is a concept by National Semiconductors (Solar Magic) wherein all power is fed through DC/DC converters that add their output powers together in a series string, hence sigma. All the prior-art concepts have problems, such as being more expensive, occupying more area, having a reduced life time and being less efficient. Below even more details are given.

As a consequence, in view of the above drawbacks and problems associated with prior-art PV modules, there still is a need for improved modules.

SUMMARY OF THE INVENTION

The present invention addresses the above problems by adding DC/DC converters on a single or multiple solar-cell level that add or subtract difference currents thereby increasing the output power of the complete PV system. As a distinguishing feature compared to state-of-the-art, the series and parallel connections of the solar modules in the PV system are left in tact.

The present invention relates to a module comprising one or more PV solar cells, preferably 4 or more PV solar cells, more preferably 32 or more PV solar cells, each solar cell preferably comprising a photosensitive layer, wherein the one or more PV solar cells are arranged in one or more series, **characterized in that** the module comprises one or more current compensators, systems comprising said modules, and a method of operating said modules. Typically the current compensator is integrated in the module. Optionally the one or more current compensators are integrated in a junction box, said junction box being typically present in or forming part of a module.

Such a module overcomes the above-mentioned problems and drawbacks.

Various differences of the present invention compared to prior art exist.

• Some prior-art solutions comprise a sigma converter. On the contrary, the present invention relates to what is further referred to as a "delta converter". Such a delta converter adds or subtracts additional current on a cell or group of cell basis, thereby compensating for differences in output between cells or groups of cells, hence the name "delta" converter. The present delta converter is typically either dimensioned for a lower power level than the sigma converter, since generally only differences in power need to be converted as opposed to full power. Alternatively, depending on the differences that one wants to compensate for, a delta converter can be dimensioned for full power. In that case, however, a lower efficiency is less critical to the total energy lost than in case of the sigma converter, since this lower efficiency is then only applicable to a limited number of converters.

- Since delta converters only convert differences in power, their efficiency has less impact on total power lost. As a result, a larger part of available solar energy is effectively delivered to an input of the central inverter. Therefore, one can realize a converter with a lower efficiency and still achieve positive effects. As a result, more energy is delivered over time in case of shading conditions when compared to a solution with sigma converters.
- Delta converters can be switched on when needed only, i.e. only when they have a positive effect on total output power. The sigma converter, however, always needs to be active.
- When retro-fitting a delta-converter solution to existing PV installations, all existing connections can be left in tact and e.g. only junction boxes need to be replaced with boxes containing (a) delta converter (s) and possibly wiring needs to be added to supply these converters.

Therefore, advantages of the present invention are amongst others:

- Due to reduced requirements, a delta converter can be realized cheaper and smaller than a sigma converter.
- Due to an allowed lower efficiency of a delta converter, its cost can be reduced even further compared to a sigma converter.
- Due to the fact that a delta converter is not always active, its lifetime will be enhanced significantly compared to a sigma converter.
- Due to a higher efficiency of a total solution comprising one or more converters, significantly more energy will be obtained over time when used in shaded conditions. This increases economical attractiveness of the present solution for installed PV systems.

The present invention further relates to:

- A series-connected string of solar cells delivering power to an output of a PV system, where differences in current between cells or groups of cells are compensated by injecting or subtracting current on a cell or group of cell basis, or both.

- A series-connected string of solar cells in a PV system, where compensation currents yield equal currents for each cell or group of cells with its associated current source.
- A series-connected string of solar cells with bidirectional current sources that are implemented by switched-mode DC/DC converters.
- A series-connected string of solar cells with added switched-mode DC/DC converters, where the DC/DC converters are controlled such that the total power generated by a PV system is maximized.

DETAILED DESCRIPTION OF THE INVENTION

In a first aspect the present invention relates to a module comprising one or more PV solar cells, preferably 4 or more PV solar cells, more preferably 32 or more PV solar cells, each solar cell preferably comprising a photosensitive layer, wherein the one or more PV solar cells are arranged in one or more series, **characterized in that** the module comprises one or more current compensators.

It is noted that the term PV solar cell refers to any type of physical element wherein solar energy, i.e. light, is converted to electrical energy. Typically nowadays such a solar cell comprises a photosensitive layer; however, any structural element, capable of converting light into electrical energy is envisaged.

Typically solar cells are combined into modules or larger entities. A module typically comprises 60 or more PV cells. Therein segments (403) can be distinguished comprising a series of solar cells and a bypass diode. Typically such a segment comprises 18-22 solar cells. Also segment (403) typically comprises connectors, going from a front side of the module to the back side thereof. These connectors are typically in connection with a junction box (404). In state-of-the-art modules a junction box will comprise one or more bypass diodes. As such the junction box is a preferred place to situate the one or more current compensators.

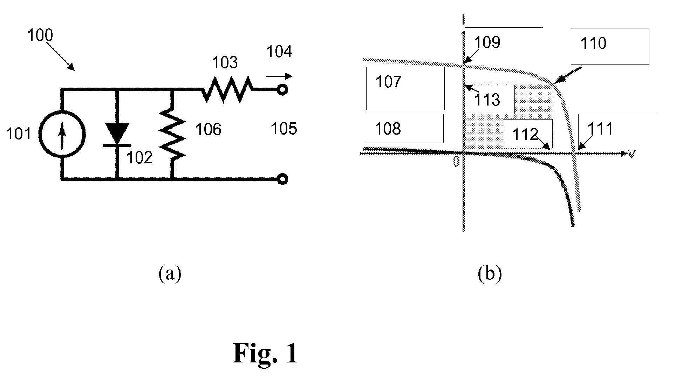

It is noted that any type of solar cell (100) can be modelled with an electrical circuit diagram as shown in Fig. 1a. Therein $I_{ins}$ (101), a photodiode (102), $R_p$ (106), $R_s$ (103), and resulting $I_{PV}$ (104) and $V_{PV}$ (105) are shown. Its accompanying I-V characteristic is shown in Fig. 1b. Therein short-circuit current $I_{sc}$ (109) in iraddiated (107) and dark (108) situations are shown, versus V. Further $V_{max}$ (112), open-circuit voltage $V_{oc}$ (111), $I_{max}$ (113) and $P_{max}$ (110) are shown. A current source $I_{ins}$ with a current value that is linearly proportional to an amount of incoming light (insolation) flows into a parallel photodiode and to an output node via a low-ohmic series resistance $R_s$ (typically a few m$\Omega$ per cell). Some internal leakage occurs via the high-ohmic resistance $R_p$ (typically in a k$\Omega$ to M$\Omega$ range). When shorted, an output current of a cell $I_{PV}$ equals the value of the current source ($I_{ins}$=short-circuit current $I_{sc}$ in the I-V characteristic in Fig. 1b). When left open-circuit, current $I_{ins}$ will flow mostly into a diode leading to an open-circuit voltage $V_{oc}$ of roughly 0.6 V, see Fig. 1b. Due to the diode in the equivalent circuit the resulting I-V characteristic is non-linear, i.e. basically a diode characteristic. The influence of the amount of incoming light is shown in Figure 1b, by comparing the I-V characteristic for two light conditions. Basically, the output current is linearly proportional to the amount of incoming light for light conditions exceeding 100 W/m², which is typical for most cases during outdoor use.

As indicated in Fig. 1b, there is typically only one point on the I-V curve where a delivered power, i.e. $I_{PV}*V_{PV}$ is maximum. In the figure, this is denoted by a $P_{max}$ point; there $I_{PV}=I_{max}$ and $V_{PV}=V_{max}$. Since a cell output current depends e.g. on amount of incoming light (insolation) and further cell behaviour is also temperature dependent, as a consequence the current and voltage value at which maximum power is obtained from a cell varies with environmental conditions. Therefore, in order to obtain a maximum output, in any practical solar system preferably this maximum power point needs to be continuously updated, which is referred to as Maximum-Power-er-Point Tracking (MPPT). In a sub-optimal configuration this is usually performed for all solar cells simultaneously.

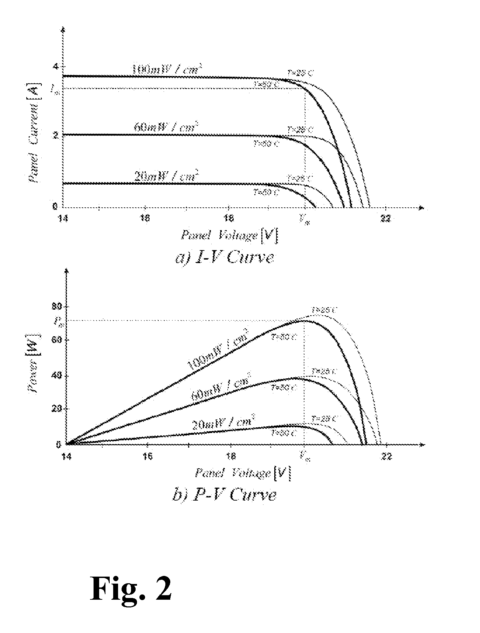

Typically a practical module consists of a number of solar cells in series. Typically, the amount of series-connected solar cells inside a module ranges from 32-72. Fig. 2 shows an example of the I-V (a) and P-V (b) characteristics of a solar module of 36 cells in series as a function of light and temperature as explained above. Practically, an amount of incoming light of 100 m W/cm² = 1000 W/m² is taken as a reference in the so-called Standard Test Condition (STC). Practical values of the insolation current $I_{ins}$ for this amount of incoming light range from 3-9 A. A current at MPP is practically 7% lower than $I_{ins}$. A practical value of MPP voltage is 0.5 V per cell, roughly 80% of $V_{oc}$. A linear dependence of $I_{ins}$ on amount of incoming light can be clearly recognized from Fig. 2a.

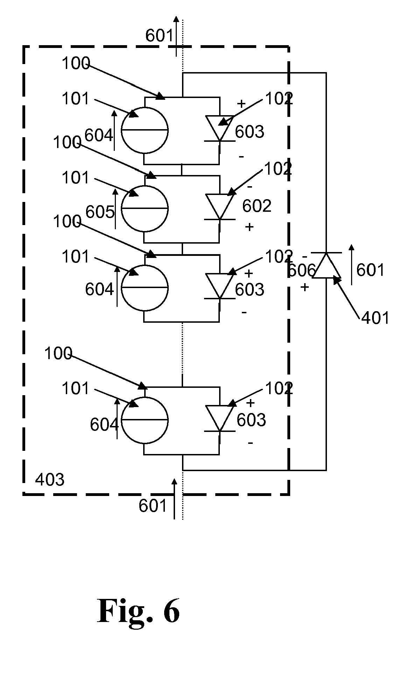

One of the major problems overcome by the present invention is decrease in output power due to sub-optimum performance of one or more PV solar cells present, e.g. due to shading, breakage, electrical disconnects, etc In order to understand why e.g. shading of even a single or a few cells may lead to a relatively large decrease in output power of a PV system, one may consider a fragment of a module depicted in Fig. 6. One bypass diode (401) is placed across 20 cells (100). An incoming light strength of 1000 W/m² is assumed with an $I_{ins}$ (101) value of 8 A (604). However, one cell has been assumed to be completely malfunctioning e.g. due to shading, which relates to an extreme case where there is zero (no) current (605) flowing. In fact, this situation arises when one cell is e.g. completely covered, e.g. with a bird dropping or leaf. As a result, all current $I_{string}$ (601) will flow through the bypass diode present and a voltage (606) across this group of 20 cells is not a possible maximum value of 20*0.5 V=10 V at MPP, but only -0.6 V (606), i.e. being the forward voltage across bypass diode 401; as a consequence, in fact energy is being wasted instead of being generated. Note that $I_{string}$ is determined by a central MPPT controller in a central inverter that tries to find an optimum point for all modules simultaneously. So, in this case, although only one single cell does not deliver power, the power of 20 cells is wasted. Note that in Figure 6 a reverse voltage (602) across a sub-optimum functioning cell such as a shaded cell becomes $19*V_{cell}-V_{bypass}=18*0.6$ V=10.8 V, with 0.6 V being the voltage 603 across the non-shaded cells with $I_{ins}$ current of 8 A (604) flowing completely in photodiode 102. In fact, this is a reason why bypass diodes are placed over 18-24 cells typically, since the reverse voltage across a shaded cell inside a module should remain limited in order to prevent damage to a solar cell.

In more extreme cases where e.g. in case of a 60-cell module only a few cells are shaded on a complete module, but in each segment (403) of e.g. 20 cells with parallel bypass diode (401) there is at least one shaded cell, the complete module will be effectively bypassed when other modules in the string are not shaded and dictate the MPP current at levels higher than the output current of the shaded cells. As a consequence the resulting module voltage in the string will be -1.8 V (3 conducting bypass diodes in series) instead of +30 V! In Fig. 5, such a situation actually occurs for the shaded module shown in the PV system on the right-hand side. Here, an antenna shadow falls across the module where the rows are organized such that the antenna shadow covers a few cells in each segment (403) in the module. Therefore, the complete module is bypassed in the string.

In PV systems with module strings in parallel, the effects can be even worse. In cases where in one string some cells are shaded, one complete string may fail to deliver output power. The reason in this case is that strings in full sunlight will dictate the voltage across a partially shaded string. Assuming that current from the non-shaded string will not flow in the shaded string due to a string diode preventing current from flowing into the string, the voltage across the shaded string may not be high enough to be able to deliver current to the system through the string diode. In all cases, the fact that the MPP is installed centrally ensures that in the found optimum point whole modules will not take part in generating power, even if only a few solar cells are covered/shaded.

The above-described problem of output differences between solar modules in a PV system and the associated power drop is clearly recognized in the field. In fact, a recent survey where PV installers were interviewed showed that partial shading is hampering 41 % of the solar installers in practice. For these installers, 87% will design 'around' regions that are shaded during part of the day, significantly reducing the amount of modules that can be placed on roofs and thereby increasing system cost. Another 28% of these installers frequently or always tell the owner that no PV system can be installed. The common solution route is to add power converters, either DC/DC or DC/AC, to the PV system, basically moving from a single central power converter to a distributed system, also implying lower power levels per converter than valid at the input of the central inverter. In fact, power conversion is decentralized to module or string levels. The known prior-art solutions can be classified as follows:

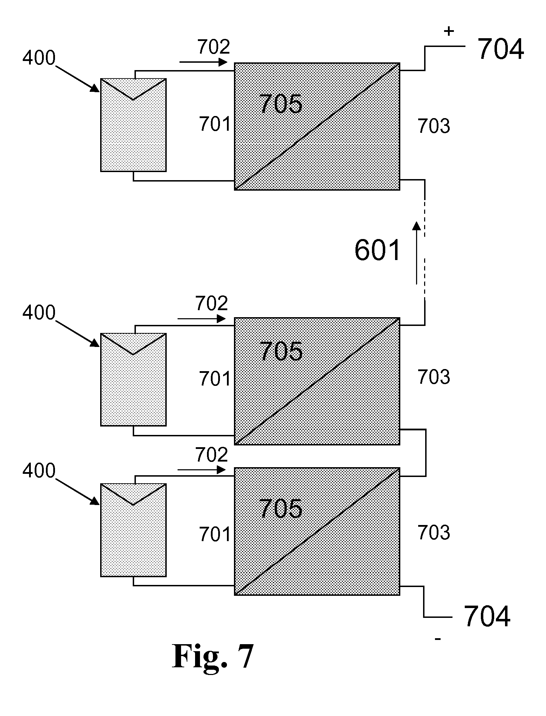

- Module-level DC/DC converters
  This solution has been proposed by National Semiconductors and is called SolarMagic. The basic idea is that modules are no longer connected in series as is shown in Figure 7. Each module (400) is connected to its own DC/DC converter (705), the outputs (703) of which are placed in series again. Each DC/DC converter installs the connected solar module at its individual MPP. Therefore, even if a module is shaded, it can still contribute to the output power of the string, since it can operate at a lower current because the module current has been decoupled from the string current. This has a positive impact on the total output power in case of differences between module output powers. At its output, the DC/DC converter adds this power to that of the others, simply by adapting its output voltage (703) to the current that is flowing in the string (601) of series-connected DC/DC converters. Since all output powers are added, these DC/DC converters could also be dubbed 'sigma' converters. A schematic is shown in Figure 7 as illustration. Therein $V_{in}$ (701), $I_{in}$ (702) are further shown. Note that the central inverter (DC/AC) remains in place in this case. By adding DC/DC converters per module, the output power (704) coming from the PV system and fed through the inverter is increased in case of partial shading or other sources of differences.

- String-level DC/DC converters
  This solution has been proposed by ACT Solar. By making strings independent of each other, the effect that a string with several shaded cells/modules cannot deliver any power anymore, since the parallel voltage imposed by the other strings in full sunlight is too high, is cancelled. Basically, they combat what they refer to as 'asymmetry effects' in PV arrays with parallel strings. With the individual DC/DC converter, each string is kept at its MPP. As is the case with SolarMagic, or in fact any solution where DC/DC converters are added to the PV array, the central inverter remains in place. As opposed to the Solar-Magic solution, the modules in a string remain connected in series as in a normal PV system.

- Module-level DC/AC converters (micro inverters)
  This solution has been proposed by various parties. In this case, the central inverter is removed and replaced by various inverters further down the chain. In all known cases, one inverter is added per module. In this case, each inverter installs the solar module it is connected to at its MPP. The modules themselves are therefore no longer connected in series, but remain independent of each other as in the SolarMagic case. This has a benificial effect on the total output power in case of differences between modules. The difference with the SolarMagic solution is that now all inverter outputs are connected in parallel, together directly delivering power to the mains grid. This solution is also often referred to as micro inverters.

A main problem that is addressed in the present invention is the fact that even small output differences between cells in PV systems may lead to a large decrease in output power. For example, as described above, only a few shaded cells in a module may lead to the complete module no longer contributing to the output power of the PV system. This problem is also recognized by various competitors as described above, but each of the presented solutions has related problems. These problems are summarized below.

- SolarMagic module-level sigma DC/DC converters
- All PV system power is fed through DC/DC converters. Since the efficiency of these converters will be lower than 100%, this leads to a decrease in possible output power. Realizing that in normal conditions shading will only occur during part of the day, during most of the day all modules will be in broad sunlight and power is effectively wasted.
- The DC/DC converter needs to be dimensioned for maximum module output power (e.g. 200 W) at high efficiency. This has a negative impact on the converter size, weight and cost.
- The DC/DC converters need to be always active. Although the efficiency needs to be high as described above, due to the direct impact on the total output power, the power fed through the converter will still be in the 200-W range in practical cases. This leads to 10 W of generated heat for a 95% efficiency DC/DC converter. The associated heating of the components in the DC/DC converter will lead to a reduction in life time.
- In case one cell is shaded in one module, the MPP of the complete module will be the voltage-current combination where the segment (403) e.g. comprising 20 cells including the shaded cell will be bypassed, and the output power is delivered by the remaining 40 cells (in case of a 60-cell module).
- When fitting these SolarMagic modules to existing PV systems, the existing connections between modules need to be disconnected and DC/DC-converter modules need to be placed in between.
- String-level DC/DC converters
- Since DC/DC converters are added on string level instead of module level, differences between cells/modules inside the string cannot be compensated. Only differences between strings can be cancelled. This implies that although the amount of needed hardware is less compared to module-level DC/DC converters, the obtained gain in system energy output is also less.

- Micro inverters
- As in the case of sigma DC/DC converters per module, the inverter needs to be dimensioned for maximum module power, with associated negative impact on cost and size.
- As for the sigma DC/DC converter, the efficiency of the inverter always impacts the total output power of the system. An advantage compared to adding sigma DC/DC converters is that in this case there is only one converter in the path, whereas for the sigma case there are two in series (sigma converter and central inverter).
- As for the sigma DC/DC converter, the inverter is always active with associated negative effect on life time.
- As for the sigma DC/DC converter, when one cell is shaded, the complete segment (403) will no longer contribute to the output power due to the bypass diode (401).
- When adding micro inverters to an existing PV system, modules no longer can be connected in series and also the wiring changes, moving from DC wiring to AC wiring.

The present invention does not have the above problems or drawbacks.

As mentioned above, individual solar cells are typically arranged in series. A series typically comprises two or more cells, such as 10 or more cells. Each series typically comprises the above bypass diodes. Typically one bypass diode per group of 18-24 solar cells is present.

The present invention relates to modules comprising one or more PV solar cells, **characterized in that** the module comprises one or more current compensators. Each compensator is in electrical connection to one or more PV solar cells. In a preferred embodiment at least one compensator is present per segment (403) of solar cells, more preferred is one compensator per half a segment (403) of solar cells, even more preferred is one compensator per 4 PV solar cells, even more preferred is one compensator per 2 PV solar cells, and most preferred is one compensator per PV solar cell. The present current compensator is capable of compensating for current differences in the order of the maximum current output of the module. Nowadays, such output is typically 8A. Current compensation can be done in two ways; adding a current to a module with a relatively lower current, which is typically lower than an average current, and removing a current from a module with a relatively higher current. Also combinations of current compensation are envisaged, such as in more complex systems, e.g. comprising many modules. By using one or more current compensators, which current compensators can then be considered to be in an active state, one module having a lower or no output can still provide a significantly higher output at a relatively low cost, namely the addition of one or more compensators to the module, and possibly some output loss in another module.

In a preferred embodiment the invention relates to a module, wherein the current compensator is a DC/DC converter, such as a bidirectional converter, wherein the converter is preferably a switched-mode converter, such as a flyback converter, preferably a unidirectional flyback converter.

In electronic engineering, a DC/DC converter is an electronic circuit, which converts a source of direct current (DC) from one voltage level to another. It is a class of power converter. A bi-directional converter offers power conversion between both a first voltage to a second voltage and a second voltage to a first voltage. The converter typically utilizes common magnetic components such as a transformer and a filter inductor and dual-function built-in diodes across transistors. Such a converter also typically utilizes a bridge converter, a push-pull converter, and a boost converter. A switched-mode power supply (also switching-mode power supply and SMPS) is an electronic power supply unit (PSU) that incorporates a switching regulator. While a linear regulator maintains the desired output voltage by dissipating excess power in a pass power transistor, the switched-mode power supply switches a power transistor between saturation (full on) and cutoff (completely off) with a variable duty cycle whose average is the desired output voltage. It switches at a much higher frequency (tens to hundreds of kHz) than that of the AC line (mains), which means that the transformer that it feeds can be much smaller than one connected directly to the line/mains. Switching creates a rectangular waveform that typically goes to the primary of the transformer; typically several secondary-side rectifiers, series inductors, and filter capacitors provide various DC outputs with low ripple. The main advantage of this method is greater efficiency because the switching transistor dissipates little power in the saturated state and the off state compared to the semiconducting state (active region). Other advantages include smaller size and lighter weight (from the elimination of low-frequency transformers which have a high weight) and lower heat generation due to higher efficiency. Disadvantages include greater complexity, the generation of high-amplitude, high-frequency energy that the low-pass filter must block to avoid electromagnetic interference (EMI), and a ripple voltage at the switching frequency and the harmonic frequencies thereof. The flyback converter is a DC/DC converter with a galvanic isolation between the input and the output(s). More precisely, the flyback converter is a buck-boost converter with the inductor split to form a transformer, so that the voltage ratios are multiplied with an additional advantage of isolation. When driving for example a plasma lamp or a voltage multiplier the rectifying diode of the Buck-Boost converter is left out and the device is called a flyback transformer. It is equivalent to that of a buck-boost converter, with the inductor split to form a transformer. Therefore the operating principle of both converters is very close: When the switch is on, the primary of the transformer is directly connected to the input voltage source. This results in an increase of magnetic flux in the transformer. The voltage across the secondary winding is negative, so the diode is reverse-biased (i.e. blocked). The output capacitor supplies energy to the output load. When the switch is off, the energy stored in the transformer is transferred to the output of the converter.

There are two configurations of a flyback converter in operation: In the on-state, the energy is transferred from the input voltage source to the transformer (the output capacitor supplies energy to the output load). In the off-state, the energy is transferred from the transformer to the output load (and the output capacitor). The flyback converter may form an isolated power converter, in which case the isolation of the control circuit is also needed. The two prevailing control schemes are voltage-mode control and current-mode control. Both require a signal related to the output voltage. There are three common ways to generate this voltage. The first is to use an optocoupler on the secondary circuitry to send a signal to the controller. The second is to wind a separate winding on the coil and rely on the cross regulation of the design. The third is to use the reflected output voltage on the primary side during the flyback stroke (primary sensing).

In a preferred embodiment the invention relates to a module, further comprising one or more of a central controller, a monitor device, an isolated input, and an isolated output.

A central controller can be used to optimize the output, e.g. in terms of number of active modules, actually delivering power, versus a prior-art situation wherein modules might even consume power. Such a controller calculates on-line, i.e. at any point in time, an optimum combination of active current compensators, both in terms of number of active current compensators and in terms of numbers of current compensators delivering a current and removing a current. As such, a maximum output of a system, comprising one ore more modules, is provided.

A monitor device can be used to monitor individual performance of cells, segments, modules etc. As such it can be used to provide input to optimize performance of the present module.

Typically a DC/DC converter inside the module will comprise an isolated input and an isolated output.

Typically a module will have various components integrated. Such is advantageous in terms of costs, performance, area used, etc.

In a second aspect the present invention relates to a string, comprising two or more modules according to the invention. Typically the present modules are combined to strings, wherein the modules are placed in series.

In a third aspect the present invention relates to an array, comprising two or more parallel strings according to the invention. Typically the present strings are combined to arrays.

In a fourth aspect the present invention relates to a system, such as a stand-alone system, a residential system, a commercial system, or a solar plant, comprising two or more modules according to the invention, and/or comprising one or more strings according to the invention, and/or comprising one or more arrays according to the invention. Typically the present modules, strings, and/or arrays are combined to larger units, as mentioned above. Such is a process of scaling up facilities.

In a fifth aspect the present invention relates to a method of operating two or more modules according to the invention, wherein a first solar cell provides a current output lower than a current output of a second solar cell, wherein a compensator provides a current to the first solar cell, or wherein a compensator subtracts a current from the second solar cell, and wherein the current is substantially equal to the difference between the current outputs of the first and second solar cell, respectively.

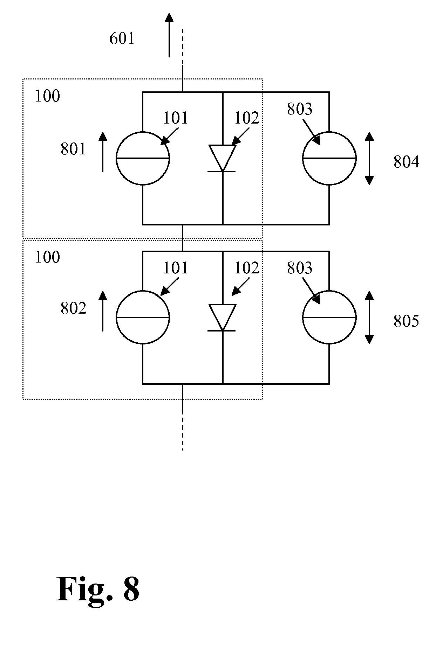

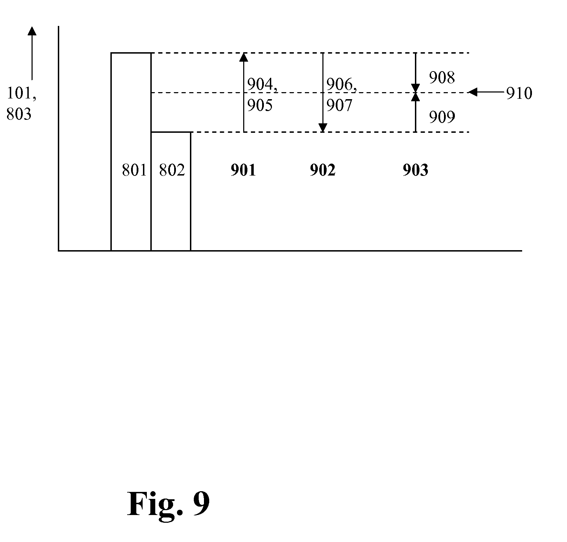

In this respect reference is made to Figs. 8 and 9 below.

In a preferred embodiment the invention relates to a method, comprising a number of active compensators, wherein the number of active compensators is minimum. In order to provide a maximum output the number of active compensators is preferably minimum. Using e.g. logical assumptions, an optimized output can be provided by determining a minimum set of active compensators.

In a preferred embodiment the invention relates to a method, wherein more than one first solar cells are present providing a current output lower than a current output of more than one second solar cells, wherein one or more current compensators provide a current to the more than one first solar cells and wherein one or more current compensators subtract a current from the more than one second solar cells. Typically in a module one or more, first, solar cells provide a lower output, whereas, at the same time, one or more, second, solar cells provide a higher output. As such a need exists to compensate for the lower output by providing a current thereto, whereas a need exists to compensate for the higher output by subtracting a current thereof. As such, the current subtracted may at the same time be provided to the first cells. Alternatively, the current may in some form be added to the total PV-system output current. In general, a complex combination of currents subtracted and provided, respectively exists. Preferably the number of active compensators is minimum, as described above.

The present invention is further elucidated by the following figures and examples, which are not intended to limit the scope of the invention. The person skilled in the art will understand that various embodiments may be combined.

BRIEF DESCRIPTION OF THE DRAWINGS

Fig. 1: (a) Equivalent circuit model of a solar cell, (b) I-V characteristic of solar cell for two light conditions.

Fig. 2: (a) I-V and (b) P-V characteristic of solar module with 36 solar cells in series as a function of incoming light [mW/cm$^2$] and temperature [°C].

Fig. 3: PV system categories illustrated: (a) standalone, (b) residential, (c) commercial, (d) solar plant.

Fig. 4: Schematic of construction of a 60-cell solar module, including 3 bypass diodes placed in a junction box attached to the backside of the solar module.

Fig. 5: Some examples of partial shading in practical PV systems.

Fig. 6: Group of 20 cells with bypass diode across it. One cell is completely covered, having zero output current.

Fig. 7: National Semiconductor's SolarMagic solution.

Fig. 8: Basic idea of two solar cells in series with compensation current sources.

Fig. 9: Illustration of possible scenarios to add or subtract currents to cancel differences between output currents of solar cells.

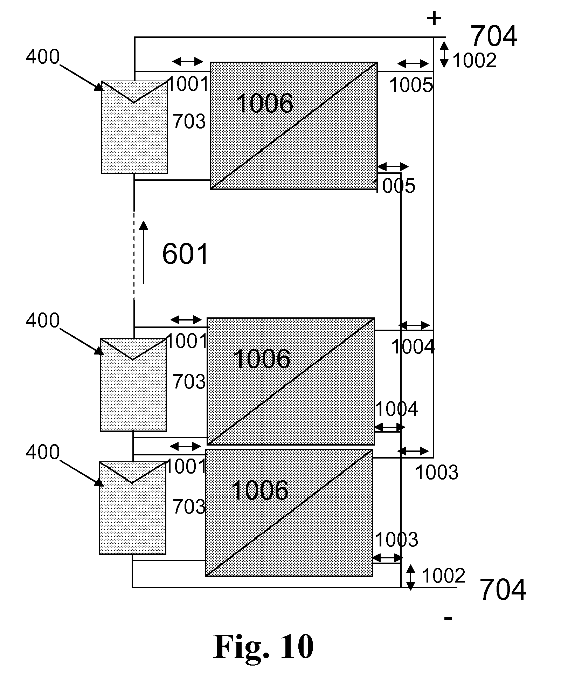

Fig. 10: Basic idea of applying one delta DC/DC converter per module.

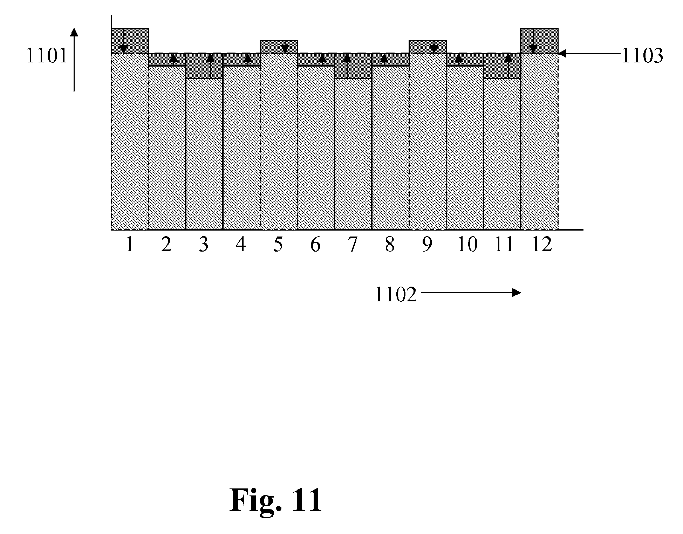

Fig. 11: Histogram of output powers of modules in a string, showing power delivered by the string in relation to power converted by delta DC/DC converters, one for each module.

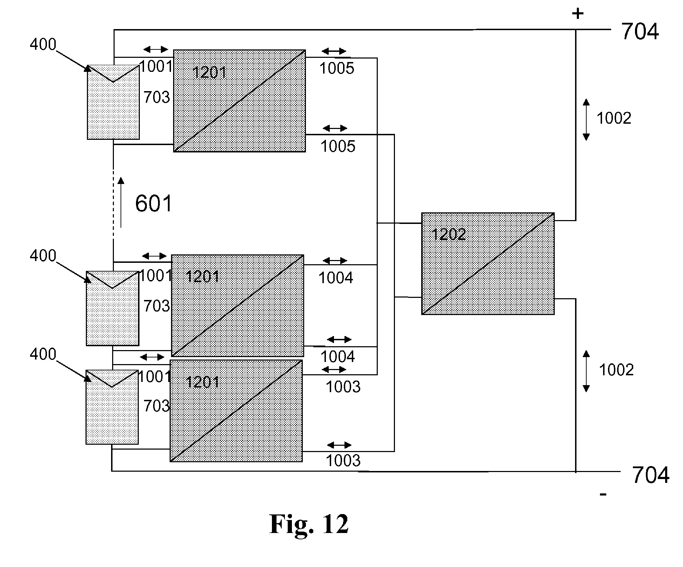

Fig. 12: PV system with delta DC/DC converters supplied from intermediate DC/DC converter.

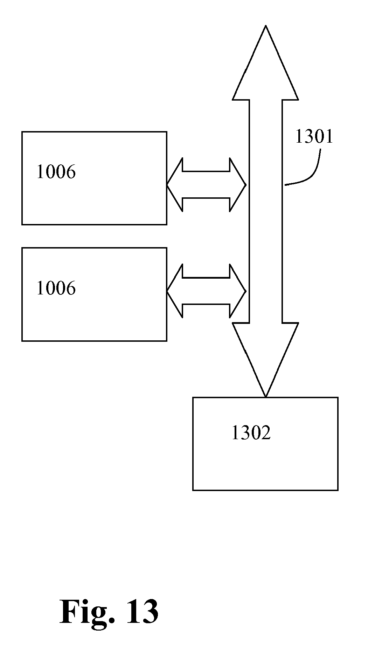

Fig. 13: Embodiment of PV system with delta converters that are connected to communication bus.

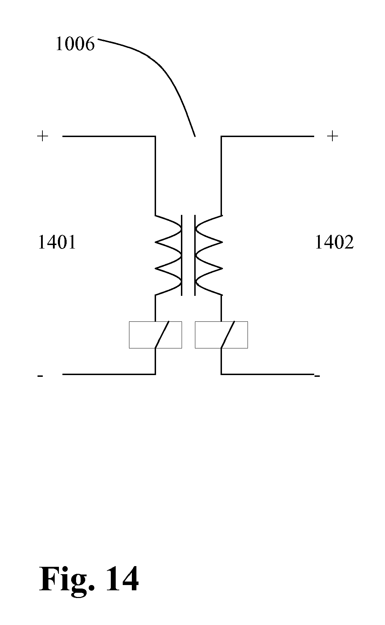

Fig. 14: Basic embodiment of a bidirectional DC/DC converter with isolated input and output terminals.

DETAILED DESCRIPTION OF THE DRAWINGS

A basic idea of the present solution is shown in Fig. 8. The figure shows two solar cells (100) in series with different insolation levels with associated different insolation currents $I_{ins,1}$ (801) and $I_{ins,2}$ (802). As a result, the lowest of these two insolation currents will determine the output power of the two series-connected cells. The basic idea is to add compensation current sources per cell that deliver current to the cell with the lowest $I_{ins}$ value and/or subtract current from the cell with the highest $I_{ins}$ value such that the net currents per cell are equal. The effect of this solution is that the PV system now behaves like a system wherein all insolation currents of the solar cells are the same. Therefore, the negative effects of insolation differences between cells have been effectively compensated for. This is expressed as follows:

$$I_{ins,1} + \Delta I_1 = I_{ins,2} + \Delta I_2$$

The current sources per cell depicted in Fig. 8 are implemented with DC/DC converters (803). In its most versatile form, the current sources are bidirectional. Other implementations with unidirectional sources are also be envisioned. The associated power of adding or subtracting currents at the valid voltage level is either subtracted from or delivered to the PV system. Since the DC/DC converters compensate differences between cells, these converters can be named delta converters, as opposed to the sigma converters described above in the state-of-the-art. Further shown are different copensation-current values $\Delta I_1$ (804) and $\Delta I_2$ (805), solar cells (100), and the string current (601) imposed by the central MPPT controller.

Fig. 9 illustrates possible scenarios for the example case where $I_{ins,1}$ (801)>$I_{ins,2}$(802). Further $\Delta I$ (803) and $I_{ins}$(101) values are shown. In scenario (901), only current is added to solar cell 2, so $\Delta I_1$ =0 (condition 904) and $\Delta I_2$ =$I_{ins,1}$-$I_{ins,2}$>0 (condition 905). In scenario (902), only current is subtracted from solar cell 1, so $\Delta I_1$ = $I_{ins,2}$ - $I_{ins,1}$<0 (condition 906) and $\Delta I_2$ =0 (condition 907). In scenario (903), current is subtracted from solar cell 1 and current is added to solar cell 2, so $\Delta I_1$ =( $I_{ins,2}$-$I_{ins,1}$)/2<0 (condition 908) and $\Delta I_2$ =( $I_{ins,1}$ - $I_{ins,2}$)/2>0 (condition 909). The net result in all cases is that the virtual insolation currents of the cells are equal. In scenario 901, the net insolation current equals $I_{ins,1}$ (801) in scenario 902 it is $I_{ins,2}$ (802) and in scenario 903 it is ($I_{ins,1}$+ $I_{ins,2}$)/2 (910).

The same idea can be applied to more than one cell in series. For example, one DC/DC converter can be added per segment of cells that is bypassed by one bypass diode, or one DC/DC converter can be added per module. The latter case is illustrated in Fig. 10. The basic idea remains the same: the DC/DC converters will deliver or subtract the difference in current to or from the associated cells ($I_{out}$). The needed power for this is subtracted from the PV system ($I_{in}$) (in case additional current is delivered to the cells) or delivered to the PV system (in case current is subtracted from the associated cells).

As can be seen in Fig. 10, the series connection of the modules remains in place. As a result, the bulk of the output power is delivered directly by the string and not by the delta DC/DC converters (1006). This leads to the mentioned power-efficiency advantages relative to Fig. 7 where all the power has to be fed through the DC/DC converters. This is further illustrated in Fig. 11. Fig. 11 depicts the output powers of several modules (1, 2, ..12) in a string (1102), in which differences occur. The power (1101) delivered by the string is depicted at the bottom, whereas the power converted through the delta converters (in the depicted case of a bidirectional implementation, a unipolar implementation is of course also possible) is depicted at the top. Downward arrows denote that the delta converter connected to the module subtracts current from the module, whereas upward arrows denote that the delta converter connected to the module adds current to the module. The net result is that all modules behave as if they operate all at the same insolation level yielding the denoted average output power (1103). Since the differences in practice will be considerably lower than 100%, the bulk of the power delivered by the string will be considerably higher than the power converted by the delta converters. This has a positive impact on the cost and efficiency , as described above.

Various methods can be envisioned to implement the basic idea described above. First of all, in the embodiment of Fig. 10 the inputs of the delta converters are connected in parallel to the total string voltage. This implies that each delta converter needs to convert power between the module voltage level of e.g. 30 V (in case of a 60-cell module typical for many solar applications) and the string voltage level of e.g. 300 V (in case of 10 modules in series in a string). An alternative would be to generate an intermediate voltage centrally in the system from which all delta converters are supplied. The objective is to provide a lower-voltage solution for all delta converters in the system and having only one central high-voltage DC/DC converter. The fact that there is only one central DC/DC converter to convert the high string voltage to a lower intermediate voltage allows for optimizing its efficiency since its added cost has less impact on the total cost than that of the multitude of low-voltage DC/DC delta converters. This is depicted in Fig. 12, where only one string is shown. In case of multiple parallel strings there will be one central HV DC/DC converter (1202) converting the string voltage into a suitable intermediate voltage for all module delta DC/DC converters (1201). The intermediate voltage could for example be in the same voltage range as the output voltage of the low-voltage DC/DC converters, e.g. 30 V for a 60-cell module. Alternatively, the intermediate voltage could be chosen on voltage-breakdown limitations of cost-effective IC technology, e.g. 100 V for automotive Silicon-on-Insulator (SoI) technology.

In order to control the current delivered or consumed by the delta converters, one could envision the use of a central control function. This is depicted in Fig. 13. Here all delta converters (1006) (only two shown for simplicity, connections to modules and string, whether or not via intermediate supply also left out for simplicity) are connected to each other via a communication bus (1301) that is also fed to a central control function (1302). Alternatively, the delta converters could also determine the current to be delivered or subtracted individually.

In order to ensure that the delta converters lead to a positive effect, the total output power of the PV system is monitored in the central MPPT algorithm. This algorithm still resides inside the central inverter. The information of this MPP may be fed back to the delta converters, optionally via some form of central control function overseeing the delta-converter operation to find the optimum operating point.

A known basic embodiment of a bidirectional DC/DC converter (1006) that allows for different input (1401) and output terminal (1402) voltage levels due to the isolation obtained using a transformer/coupled set of coils is depicted in Figure 14. Unidirectional versions can be derived from this figure by replacing one of the switches by a diode.

Other, more detailed embodiments can be envisioned. For example, a specific example of a unidirectional converter is a flyback converter that can only deliver current to modules. This is a likely embodiment, since in most cases the number of shaded modules will be low compared to the number of modules in the sun, increasing the likeliness that only for a few modules current needs to be delivered. Depending on the construction of the solar module, the flyback converter can be given multiple outputs, e.g. one output per section normally bridged by a bypass diode. This multi-output converter, or one converter per bypass section, may be placed in the junction box, either in combination with the existing bypass diodes or replacing them.

## Claims

1.  Module (400) comprising one or more PV solar cells (100), preferably 4 or more PV solar cells, more preferably 32 or more PV solar cells, each solar cell preferably comprising a photosensitive layer, wherein the one or more PV solar cells are arranged in one or more series, **characterized in that** the module comprises one or more current compensators.

2.  Module according to claim 1, wherein the current compensator is a DC/DC converter, such as a bidirectional converter, wherein the converter is preferably a switched-mode converter, such as a flyback converter, preferably a unidirectional flyback converter.

3.  Module according to any of claims 1-2, further comprising one or more of a central controller, a monitor device, an isolated input, and an isolated output.

4.  String, comprising two or more modules according to any of claims 1-3 in series.

5.  Array, comprising two or more parallel strings according to claim 4.

6.  System, such as a stand-alone system, a residential system, a commercial system, or a solar plant, comprising two or more modules according to any of claims 1-3, and/or comprising one or more strings according to claim 4, and/or comprising one or more arrays according to claim 5.

7.  Method of operating two or more modules according to any of claims 1-3, wherein a first solar cell provides a current output lower than a current output of a second solar cell, wherein a compensator provides a current to the first solar cell, or wherein a compensator subtracts a current from the second solar cell, and wherein the current is substantially equal to the difference between the current outputs of the first and second solar cell, respectively.

8. Method according to claim 7, comprising a number of active compensators, wherein the number of active compensators is minimal.

9. Method according to claim 7 or claim 8, wherein more than one first solar cells are present providing a current output lower than a current output of more than one second solar cells, wherein one or more current compensators provide a current to the more than one first solar cells and wherein one or more current compensators subtract a current from the more than one second solar cells.

(a)

(b)

# Fig. 1

a) I-V Curve

b) P-V Curve

Fig. 2

(a)  (b)  (c)  (d)

# Fig. 3

**Fig. 4**

501

**Fig. 5**

# Fig. 6

**Fig. 7**

**Fig. 8**

**Fig. 9**

**Fig. 10**

**Fig. 11**

**Fig. 12**

**Fig. 13**

**Fig. 14**

Europäisches
Patentamt

European
Patent Office

Office européen
des brevets

**EUROPEAN SEARCH REPORT**

Application Number

EP 09 15 9824

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DE 102 19 956 A1 (WEBASTO VEHICLE SYS INT GMBH [DE]) 30 April 2003 (2003-04-30) * abstract; figures 1-6 * * paragraphs [0028], [0033], [0034] *  ----- | 1-9 | INV. H02J7/35 H01L31/02 |
| X | US 2005/139258 A1 (LIU YUNG-HSIANG [TW] ET AL) 30 June 2005 (2005-06-30) * figure 1 * * paragraphs [0007], [0010], [0011] * * paragraphs [0019], [0021], [0023], [0025] * * figure 1 *  ----- | 1-9 | |
| | | | TECHNICAL FIELDS SEARCHED (IPC) |
| | | | H02J H01L |

The present search report has been drawn up for all claims

| Place of search | Date of completion of the search | Examiner |
|---|---|---|
| The Hague | 13 November 2009 | Marannino, M |

EPO FORM 1503 03.82 (P04C01)

## ANNEX TO THE EUROPEAN SEARCH REPORT
## ON EUROPEAN PATENT APPLICATION NO.

EP 09 15 9824

This annex lists the patent family members relating to the patent documents cited in the above-mentioned European search report.
The members are as contained in the European Patent Office EDP file on
The European Patent Office is in no way liable for these particulars which are merely given for the purpose of information.

13-11-2009

| Patent document cited in search report | | Publication date | Patent family member(s) | Publication date |
|---|---|---|---|---|
| DE 10219956 | A1 | 30-04-2003 | NONE | |
| US 2005139258 | A1 | 30-06-2005 | NONE | |

EPO FORM P0459

For more details about this annex : see Official Journal of the European Patent Office, No. 12/82